# EUROPÄISCHE PATENTSCHRIFT

(11) **EP 2 318 850 B1**
(45) Veröffentlichungstag und Bekanntmachung des Hinweises auf die Patenterteilung: **01.01.2020**
(21) Anmeldenummer: 09744592.8
(22) Anmeldetag: 12.08.2009
(51) Int. Cl.: G01R 27/26, G01R 19/25

(54) **ANORDNUNG ZUR MESSUNG WENIGSTENS EINES WERTES EINER AN EINER ELEKTRONISCHEN KOMPONENTE ANLIEGENDEN SPANNUNG**
ARRANGEMENT FOR MEASURING AT LEAST ONE VALUE OF A VOLTAGE APPLIED TO AN ELECTRONIC COMPONENT
DISPOSITIF SERVANT À MESURER AU MOINS UNE VALEUR D'UNE TENSION ASSOCIÉE À UN COMPOSANT ÉLECTRONIQUE

(30) Priorität: 29.08.2008 DE 102008044908
(43) Veröffentlichungstag der Anmeldung: 11.05.2011
(73) Patentinhaber: Lemförder-Electronic GmbH, 32339 Espelkamp (DE)
(72) Erfinder: HAEVESCHER, Rainer, 32351 Stemwede (DE)
(74) Vertreter: Gebhard, Wolfgang
(86) Internationale Anmeldenummer: PCT/DE2009/001121
(87) Internationale Veröffentlichungsnummer: WO 2010/022700

(56) Entgegenhaltungen:
- EP-A- 0 288 215
- EP-A- 0 438 103
- WO-A-94/22026
- DE-A1- 10 118 299
- US-A- 4 649 341
- US-A- 4 683 417

## Beschreibung

Die Erfindung betrifft eine Anordnung zur Messung wenigstens eines Wertes einer an einer elektronischen Komponente anliegenden Spannung. Ferner betrifft die Erfindung ein verfahren zur Abtastung wenigstens eines wertes einer an einer elektronischen Komponente auftretenden Signalflanke.

Die WO 94/22026 A1 offenbart ein Verfahren zum Messen der Kapazität eines Kondensators, der elektrisch mit einem Detektorkreis verbunden wird, der eine bekannte und mit dem Kondensator in Reihe geschaltete Impedanz umfasst. Eine Eingangsspannung bekannter Wellenform wird mittels eines Impulsgenerators an den Detektorkreis angelegt, und nach Ablauf einer bekannten Zeitspanne wird der Augenblickswert der an dem Kondensator oder an der Impedanz anliegenden Spannung gemessen und mittels eines Analog-Digitalwandlers digitalisiert. Anschließend wird die Kapazität des Kondensators berechnet. Dabei können der Impulsgenerator, die Abtast-und-Haltefunktion sowie der Analog-Digitalwandler von demselben Mikrocontroller gesteuert werden.

Die US 4 683 417 A beschreibt ein Verfahren zum Testen von Kondensatoren und dielektrischen Materialen, wobei der zu testende Gegenstand mit einer Referenzimpedanz innerhalb einer Messkette in Reihe geschaltet wird- An die Messkette werden wiederholt Spannungsimpulse angelegt, und ein Augenblickswert der Impulsantwort jedes Spannungsimpulses wird gemessen. Dabei werden die Messzeitpunkte der Augenblickswerte von Messung zu Messung zeitlich nach hinten verschoben. Die abgetasteten Werte werden unter Zwischenschaltung einer Abtast-Halte-Schaltung einem Analog-Digitalwandler zugeführt.

Die US 4 649 341 A offenbart eine Anordnung zum Bestimmen der Position eines Spulenkerns, wobei an die Spule auf einen Spannungsimpuls hin eine Spannung angelegt wird. Der Strom durch die Spule ändert sich, bis ein vorgegebener Stromwert erreicht wird oder eine vorbestimmte Zeitdauer abgelaufen ist. Gemäß einer Variante wird ein Kondensator über die Spule geladen, dann von der Spule getrennt und anschließend über einen Widerstand entladen. In dem Moment, in dem der Kondensator von der Spule getrennt wird, wird auch die Spule von der Spannung getrennt. Mittels eines Mikroprozessors wird während des Entladens des Kondensators die Zeit gemessen, bis die an diesem anliegende Spannung auf einen Schwellenwert abgefallen ist.

Die EP 0 288 215 A2 beschreibt eine Vorrichtung zur Bestimmung der Kapazität und des Widerstands einer elektrischen Komponente, die einer variablen Spannung ausgesetzt wird, die sich von einer ersten Polarität bis zu einer zweiten Polaritët linear ändert und dann konstant bleibt. Die elektrische Komponente ist über einen Verstärker und eine Abtast-Halte-Schaltung an einen Analog-Digitalwandler angeschlossen, der mit einer Steuerung verbundenen ist. Bei einem Nulldurchgang der Spannung wird das an der elektrischen Komponente anliegende Potential gemessen und daraus die Kapazität bestimmt. Ferner wird im konstanten Bereich der Spannung das an der elektrischen Komponente anliegende Potential gemessen und daraus der widerstand bestimmt.

Aus der EP 0 438 103 A2 ist ein verfahren zum Messen physikalischer Größen bekannt, bei dem ein periodisches Speisesignal abgegeben und ein Antwortsignal ausgewertet wird. Das Speisesignal weist eine vorgegebene Signalform auf, wobei das Antwortsignal während wenigstens einer Signalperiode an wenigstens einem diskreten Zeitpunkt abgefragt wird, und wobei der wenigstens eine diskrete Abfragewert ausgewertet wird. Die Abfragewerte werden zur Ermittlung von Materialeigenschaften ausgewertet, wobei die Art des Materials durch Auswertung der Abfragewerte ermittelt wird. Ferner ist ein Signalaufnehmer vorgesehen, der eine Abtastschaltung zum Abfragen des Antwortsignals während wenigstens einer Signalperiode an wenigstens einem diskreten Zeitpunkt aufweist und eine Sample-and Hold-Schaltunq umfassen kann.

Es gibt verschiedene Verfahren, um Induktivitäts-/Kapazitäts-Werte zu messen. Insbesondere mit Blick auf ein Mikroprozessor-Messsystem für kleine Induktivitäts-/Kapazitäts-Werte und eine gegebenenfalls hohe Anzahl an Messkanälen gibt es eine Reihe von Nachteilen. Zum einen führt die hohe Anzahl analoger Bauelemente zu einem hohen Platzbedarf und zu hohen Kosten. Zum anderen sind derartige Messsysteme anfällig gegenüber Umwelteinflüssen, z.B. gegenüber Temperaturschwankungen. Ferner ist die Realisierung mit einem Mirkoprozessor aufwendig.

Ein typisches Messprinzip zur Erfassung von Induktivitäten und Kapazitäten ist es, für die Lade- oder Entladekurve im Strom- oder Spannungsverlauf die Zeit bis zum Erreichen eines Schwellenwertes zu messen. Nachteilig ist dabei, dass die Messung kleiner Induktivitäts- und Kapazitäts-Werte schwierig ist. Ferner ist nachteilig, dass Toleranzen des Schwellenwertschalters das Messergebnis stark beeinflussen. Schließlich ist nachteilig, dass der Messbereich bei kleiner Zeitkonstante durch die Auflösung des Zeit-Zählers eingeschränkt ist.

Ein weiteres Verfahren ist das Abstimmen auf Resonanzfrequenzen, um dadurch die Induktivität oder die Kapazität zu ermitteln. Dieses verfahren ist auch für kleine Induktivitäts-/Kapazitäts-Werte geeignet.

Nachteilig ist hierbei, dass zum einen toleranzarme Bauteile erforderlich sind und zum anderen die Dauer der Messung durch die Zeit für den Frequenzdurchlauf (Frequenzsweep) relativ lang ist.

Weist die elektronische Komponente eine relativ kleine Kapazität oder Induktivität auf, so können auftretende Signalflanken, z.B. bei einer Sprungantwort der elektronischen Komponente, sehr steil sein. Zur Messung wenigstens eines Wertes einer solchen schnellen elektrischen Signalflanke ist aber regelmäßig ein schneller Analog-Digital-Wandler erforderlich, der vergleichsweise teuer ist.

Ausgehend von diesem Stand der Technik liegt der Erfindung die Aufgabe zugrunde, wenigstens einen Wert einer an einer elektronischen Komponente anliegenden Spannung auch bei relativ schnellen Signalflanken mit einer vergleichsweise kostengünstigen und einfach aufgebauten Anordnung messen zu können.

Diese Aufgabe wird erfindungsgemäß mit einer Anordnung nach Anspruch 1 und mit einem Verfahren nach Anspruch 11 gelöst. Bevorzugte Weiterbildungen der Erfindung sind in den Unteransprüchen gegeben.

Die erfindungsgemäße Anordnung zur Messung wenigstens eines Wertes einer an einer elektronischen Komponente anliegenden Spannung weist einen ersten Signalgeber, von dem ein erstes Schaltsignal abgebbar ist, einen mit dem ersten Signalgeber gekoppelten ersten Schalter, der mittels des ersten Schaltsignals schaltbar ist, wobei die elektronische Komponente mit dem ersten Schalter in Reihe geschaltet und mittels diesem mit einer elektrischen Energiequelle koppelbar ist, einen zweiten Signalgeber, von dem ein zweites Schaltsignal abgebbar ist, einen mit dem zweiten Signalgeber gekoppelten zweiten Schalter, der mittels des zweiten Schaltsignals schaltbar ist, einen kapazitiven Speicher, der mit dem zweiten Schalter in Reihe geschaltet und mittels diesem zu der elektronischen Komponente oder zu der von der elektronischen Komponente und dem ersten Schalter gebildeten Reihenschaltung parallel schaltbar ist, und einen Analog-Digital-Wandler auf, der zu dem kapazitiven Speicher parallel geschaltet ist.

Wird der erste Schalter zu einem ersten Zeitpunkt geschlossen, so wird mittels der elektrischen Energiequelle eine elektrische Spannung an die elektronische Komponente angelegt oder ein elektrischer Strom der elektronischen Komponente zugeführt, was bevorzugt zunächst zu einem Ausgleichsvorgang, insbesondere zu einer Sprungantwort, der elektronischen Komponente führt, der nach einer gewissen Zeit in einen stationären oder quasistationären Zustand übergeht. Wird der erste Schalter zu einem späteren, zweiten Schaltzeitpunkt geöffnet, so wird die elektronische Komponente abrupt von der Spannungs- und/oder Stromversorgung getrennt, was bevorzugt ebenfalls zu einem Ausgleichsvorgang, insbesondere zu einer Sprungantwort, der elektronischen Komponente führt. Jeder der Ausgleichsvorgänge hat in der Regel eine Veränderung der an der elektronischen Komponente anliegenden elektrischen Spannung zur Folge, wobei der zeitliche Verlauf der an der elektronischen Komponente anliegenden Spannung während des jeweiligen Ausgleichsvorgangs Rückschlüsse auf elektrische Eigenschaften der elektronischen Komponente zulässt.

Eine an der elektronischen Komponente anliegende Spannung liegt aber im geschlossenen Zustand des zweiten Schalters auch an dem kapazitiven Speicher an. Dabei ist die Kapazität des kapazitiven Speichers bevorzugt derart klein gewählt, dass dieser den Spannungsverlauf an der elektronischen Komponente während eines solchen Ausgleichsvorgangs möglichst wenig oder im Rahmen der gewünschten Messgenauigkeit nicht messbar beeinflusst. Wird nun zu einem Messzeitpunkt der zweite Schalter geöffnet, wird die an dem kapazitiven Speicher anliegende Spannung für eine ausreichende Zeitdauer von dem kapazitiven Speicher gehalten, so dass der Analog-Digital-Wandler diese Spannung erfassen und in ein digitales Signal umwandeln kann.

Ist der zeitliche Unterschied zwischen dem ersten Schaltzeitpunkt und dem Messzeitpunkt und/oder zwischen dem zweiten Schaltzeitpunkt und dem Messzeitpunkt bekannt, ist es möglich, die Spannung an der elektronischen Komponente zu einem bekannten Zeitpunkt nach Beginn des Ausgleichsvorgangs mittels des Analog-Digital-Wandlers zu erfassen und zu digitalisieren. Bevorzugt ist dieser zeitliche Unterschied derart gering, dass der zweite Schalter geöffnet wird, bevor der durch das Schalten des ersten Schalters hervorgerufene Ausgleichsvorgang an der elektronischen Komponente, im Rahmen der Messgenauigkeit, abgeklungen ist.

Da kurze zeitliche Unterschiede zwischen zwei Schaltsignalen bei hoher Genauigkeit mit relativ einfachen Mitteln zu erzeugen sind, ist die erfindungsgemäße Anordnung vergleichsweise kostengünstig und einfach im Aufbau realisierbar. Der Analog-Digital-Wandler muss dabei in Bezug auf seine Schnelligkeit nicht dem Ausgleichsvorgang folgen können und kann im Vergleich dazu relativ langsam arbeiten. Bevorzugt sind die Eigenschaften des kapazitiven Speichers aber an die Schnelligkeit des Analog-Digital-Wandlers angepasst, damit der kapazitive Speicher die an ihm anliegende Spannung solange im Rahmen der Messgenauigkeit hält, bis der Analog-Digital-Wandler eine Erfassung und Digitalisierung dieser Spannung durchgeführt hat.

Die elektrische Energiequelle, mittels welcher eine elektrische Spannung an die elektronische Komponente angelegt oder ein elektrischer Strom der elektronischen Komponente zugeführt wird oder werden kann, ist bevorzugt eine elektrische Spannungsquelle oder eine elektrische Stromquelle oder weist bevorzugt eine elektrische Spannungsquelle oder eine elektrische Stromquelle auf. Ist der erste Schalter geschlossen, so wird dadurch auch eine Spannung an die elektronische Komponente angelegt und/oder ein. Strom der elektronischen Komponente zugeführt. Die elektrische Energiequelle kann unmittelbar zu der Reihenschaltung aus der elektronischen Komponente und dem ersten Schalter parallel geschaltet sein. Alternativ kann die elektrische Energiequelle unter Zwischenschaltung wenigstens eines zusätzlichen elektronischen Bauelements zu dieser Reihenschaltung parallel geschaltet sein. Das wenigstens eine zusätzliche elektronische Bauelement ist z.B. von einem oder von mehreren ohmschen Widerständen gebildet oder weist diese auf. Insbesondere ist die elektronische Komponente mit der elektrischen Energiequelle unter Zwischenschaltung wenigstens eines ohmschen Widerstands gekoppelt.

Bevorzugt ist der Analog-Digital-Wandler zu dem kapazitiven Speicher direkt parallel geschaltet. Alternativ ist der Analog-Digital-Wandler unter Zwischenschaltung wenigstens eines elektronischen Bauelements parallel zu dem kapazitiven Speicher geschaltet. Dieses wenigstens eine elektronische Bauelement kann z.B. ein ohmscher Widerstand sein.

Der kapazitive Speicher weist bevorzugt wenigstens einen Kondensator auf oder ist von wenigstens einem Kondensator gebildet. Insbesondere kann der kapazitive Speicher auch wenigstens ein anderes elektronisches Bauelement umfassen.

Der erste Schalter weist bevorzugt einen Transistor auf oder ist von einem Transistor gebildet, wobei der Transistor insbesondere ein Feldeffekttransistor ist.

Der erste Signalgeber weist bevorzugt eine Pulsweitenmodulator-Einheit auf oder ist von einer Pulsweitenmodulator-Einheit gebildet. Mit einer Pulsweitenmodulator-Einheit ist es auf einfache Weise möglich, ein Signal, insbesondere ein Rechtecksignal, zu erzeugen, dessen Impulsdauer und/oder Tastverhältnis mit hoher Genauigkeit einstellbar ist. Ferner weist der zweite Signalgeber bevorzugt eine Pulsweitenmodulator-Einheit auf oder ist von einer Pulsweitenmodulator-Einheit gebildet, sodass auf einfache Weise ein Signal, insbesondere ein Rechtecksignal, mit einstellbarer Impulsdauer und/oder einstellbarem Tastverhältnis erzeugbar ist.

Das erste Schaltsignal ist bevorzugt ein Rechtecksignal oder weist bevorzugt wenigstens ein Rechtecksignal auf. Ferner ist das zweite Schaltsignal bevorzugt ein Rechtecksignal oder weist bevorzugt wenigstens ein Rechtecksignal auf. Insbesondere weist das Rechtecksignal des zweiten Schaltsignals eine unterschiedliche Impulsdauer und/oder ein unterschiedliches Tastverhältnis als das Rechtecksignal des ersten Schaltsignals auf. Bevorzugt weist das Rechtecksignal des zweiten Schaltsignals eine kürzere Impulsdauer und/oder ein kleineres Tastverhältnis als das Rechtecksignal des ersten Schaltsignals auf.

Der zweite Schalter kann ebenfalls von einem Transistor, insbesondere von einem Feldeffekttransistor, gebildet sein. Bevorzugt ist der zweite Schalter von einem Multiplexer gebildet oder mit einem Multiplexer gekoppelt. Insbesondere kann der kapazitive Speicher mittels des Multiplexers zu wenigstens einer anderen elektronischen Komponente, die insbesondere mit dem ersten Schalter in Reihe geschaltet ist, oder zu einer aus der anderen elektronischen Komponente und dem ersten Schalter gebildeten Reihenschaltung parallel geschaltet werden. Vorzugsweise ist die andere elektronische Komponente direkt oder unter Zwischenschaltung wenigstens eines elektronischen Bauelements, wie z.B. eines ohmschen Widerstands, mit der elektrischen Energiequelle gekoppelt oder koppelbar. Mittels des Multiplexeres ist es möglich, Spannungen an unterschiedlichen elektronischen Komponenten zu messen. Die unterschiedlichen elektronischen Komponenten sind dabei bevorzugt an unterschiedlichen Signaleingängen des Multiplexers angeschlossen, die somit unterschiedliche Messkanäle bilden. Der zweite Signalgeber ist insbesondere mit einem Freigabeeingang (enable) des Multiplexers verbunden.

Die beiden Signalgeber und/oder der Analog-Digital-Wandler sind bevorzugt in eine Steuereinheit integriert, die insbesondere von einem Mikroprozessor, von einem Mikrokontroller, von einem programmierbaren integrierten Schaltkreis, wie z.B. von einem FPGA, oder von einer anwendungsspezifischen integrierten Schaltung, wie z.B. von einem ASIC, gebildet ist oder diesen bzw. diese umfasst, sodass die erfindungsgemäße Anordnung äußerst platzsparend aufgebaut werden kann. Da Steuereinheiten mit integrierten Analog-Digital-Wandlern und/oder mit integrierten Signalgebern, wie z.B. Pulsweitenmodulator-Einheiten, als Massenprodukt auf dem Markt verfügbar sind, ist die erfindungsgemäße Anordnung äußerst kostengünstig realisierbar. Wie oben bereits angesprochen, ist es dabei nicht nachteilig, wenn der Analog-Digital-Wandler vergleichsweise langsam arbeitet.

Weisen die beiden Signalgeber jeweils eine Pulsweitenmodulator-Einheit auf oder sind die beiden Signalgeber jeweils durch eine Pulsweitenmodulator-Einheit gebildet, ist es auf einfache Weise möglich, die Impulsdauern und/oder die Tastverhältnisse der beiden Schaltsignale einzustellen. Somit kann auch der zeitliche Unterschied zwischen dem ersten Schaltzeitpunkt und dem Messzeitpunkt und/oder zwischen dem zweiten Schaltzeitpunkt und dem Messzeitpunkt mit großer Genauigkeit eingestellt werden, insbesondere wenn die beiden Signalgeber zeitlich aufeinander abgestimmt sind, was vorzugsweise auch der Fall ist. Diese zeitliche Abstimmung kann z.B. mittels eines gemeinsamen Taktgebers erfolgen.

Die beiden Signalgeber werden bevorzugt mittels einer gemeinsamen Steuereinrichtung gesteuert oder sind mittels dieser steuerbar, die insbesondere mittels eines Taktgebers getaktet ist, der bevorzugt ein periodisches Taktsignal erzeugt. Somit kann die Impulsdauer und/oder das Tastverhältnis jedes Schaltsignals mit der Genauigkeit eines Taktzyklus oder einem ganzzahligen Vielfachen des Taktzyklus eingestellt werden. Die Impulsdauer jedes Schaltsignals beträgt somit bevorzugt einen oder mehrere Taktzyklen. Ferner unterscheiden sich die Impulsdauern und/oder Impulsenden der beiden Schaltsignale insbesondere um einen Taktzyklus oder um ein ganzzahliges Vielfaches des Taktzyklus. Bevorzugt entspricht der zeitliche Unterschied (Zeitfenster) zwischen dem ersten Schaltzeitpunkt und dem Messzeitpunkt und/oder zwischen dem zweiten Schaltzeitpunkt und dem Messzeitpunkt einem oder einem ganzzahligen Vielfachen des Taktzyklus. Die Steuereinrichtung ist insbesondere von der oben genannten Steuereinheit gebildet, sodass die beiden Signalgeber und/oder der Analog-Digital-Wandler bevorzugt in die getaktete Steuereinrichtung integriert sind.

Insbesondere geben beide Signalgeber zum ersten Schaltzeitpunkt gleichzeitig ein Schaltsignal ab, welches bevorzugt ein Rechtecksignal ist, sodass beide Schalter gleichzeitig geschlossen werden. Durch Schließen des ersten Schalters wird, wie oben bereits beschrieben, ein Ausgleichsvorgang hervorgerufen, wobei zu dem Messzeitpunkt der kapazitive Speicher von der elektronischen Komponente getrennt wird. Der Unterschied zwischen dem ersten Schaltzeitpunkt und dem nachfolgenden Messzeitpunkt kann einem Taktzyklus oder mehreren Taktzyklen entsprechen. Ein typischer Taktzyklus oder Prozessorzyklus beträgt z.B. 50 ns. Da somit die an der elektronischen Komponente anliegende Spannung zu einem definierten Zeitpunkt nach dem Beginn des Ausgleichsvorgangs mittels des Analog-Digital-Wandler erfasst und digitalisiert werden kann, ist eine Aussage über Eigenschaften der elektronischen Komponente möglich. Um diese Eigenschaften genauer zu bestimmen, kann die Messung mit einem unterschiedlichen zeitlichen Abstand zwischen dem ersten Schaltzeitpunkt und dem Messzeitpunkt wiederholt werden. Somit kann sukzessive eine wiederkehrende Signalflanke abgetastet werden, wobei die zeitliche Auflösung der Abtastung insbesondere dem Taktzyklus oder einem ganzzahligen Vielfachen davon entspricht.

Gemäß einer Alternative hält das erste Schaltsignal den ersten Schalter solange geschlossen, bis ein möglicher Ausgleichsvorgang abgeklungen und ein stationärer oder quasistationärer Zustand erreicht ist. Wird zum zweiten Schaltzeitpunkt, insbesondere am Ende des ersten Rechtecksignals, der erste Schalter geöffnet, setzt (erneut) ein Ausgleichsvorgang ein. Zum zeitlich hinter dem zweiten Schaltzeitpunkt liegenden Messzeitpunkt wird dann der kapazitive Speicher mittels des zweiten Schalters von der elektronischen Komponente getrennt, sodass die zum Messzeitpunkt an dem kapazitiven Speicher anliegende Spannung, welche der zu diesem Zeitpunkt an der elektronischen Komponente anliegenden Spannung entspricht, mittels des Analog-Digital-Wandlers erfasst und digitalisiert werden kann. Der Messzeitpunkt liegt bevorzugt ein oder mehrere Taktzyklen hinter dem zweiten Schaltzeitpunkt. Da somit die an der elektronischen Komponente anliegende Spannung zu einem definierten Zeitpunkt nach dem Beginn des (erneuten) Ausgleichsvorgangs mittels des Analog-Digital-Wandler erfasst und digitalisiert werden kann, ist eine Aussage über Eigenschaften der elektronischen Komponente möglich. Um diese Eigenschaften genauer zu bestimmen, kann die Messung mit einem unterschiedlichen zeitlichen Abstand zwischen dem zweiten Schaltzeitpunkt und dem Messzeitpunkt wiederholt werden. Somit kann sukzessive eine wiederkehrende Signalflanke abgetastet werden, wobei die zeitliche Auflösung der Abtastung insbesondere dem Prozessorzyklus oder einem ganzzahligen Vielfachen davon entspricht. Vorzugsweise wird auch hier von beiden Signalgebern zum ersten Schaltzeitpunkt gleichzeitig ein Schaltsignal abgegeben, welches insbesondere ein Rechtecksignal ist, wodurch die beiden Schalter gleichzeitig geschlossen werden.

Wie oben beschrieben, erzeugt die Steuereinrichtung bevorzugt ein Zeitfenster von 1 bis n Taktzyklen (n ist eine natürliche Zahl), wobei das kleinste Zeitfenster einen Taktzyklus umfasst. Nicht zwingend ist, dass von beiden Signalgebern zum ersten Schaltzeitpunkt gleichzeitig ein Schaltsignal abgegeben wird. Beispielsweise kann der zweite Signalgeber auch zu einem vor oder nach dem ersten Schaltzeitpunkt liegenden Zeitpunkt das zweite Schaltsignal abgeben. Ein Taktzyklus ist bei einem Mikroprozessor oder Mikrocontroller typischerweise ein Prozessorzyklus. Ferner wird das Zeitfenster bevorzugt mittels Pulsweitenmodulation erzeugt. Es ist aber auch möglich, das Zeitfenster mit einem Software-Algorithmus zu erzeugen. Dies geht z.B. bei einem Mikrocontroller mit einem Verfahren ohne Pulsweitenmodulation mit ca. 4 bis n Taktzyklen oder bei einem FPGA ohne Pulsweitenmodulation, indem die Lösung in einer Hardwarebeschreibungssprache, wie z.B. in VHDL, beschrieben wird.

Die elektronische Komponente weist wenigstens ein elektronisches Bauelement auf, kann aber auch als elektronische Baugruppe ausgebildet sein. Bevorzugt ist die elektronische Komponente durch wenigstens einen Kondensator oder durch wenigstens eine Induktivität, wie z.B. eine elektrische Spule, gebildet.

Dem Analog-Digital-Wandler ist bevorzugt eine Auswerteeinrichtung, insbesondere eine digitale Auswerteeinrichtung nachgeschaltet, um z.B. aus dem wenigstens einen gemessenen Wert oder aus den gemessenen Werten eine Eigenschaft der elektronischen Komponente, wie z.B. deren Induktivität oder Kapazität, zu bestimmen. Dabei kann die Auswerteeinrichtung von der Steuereinheit, der Steuereinrichtung, dem Mikroprozessor und/oder Mikrokontroller gebildet sein.

Die Erfindung betrifft ferner die Verwendung der erfindungsgemäßen Anordnung zur Bestimmung einer Eigenschaft, vorzugsweise einer elektrischen Eigenschaft, insbesondere der Induktivität oder der Kapazität, der wenigstens einen elektronischen Komponente.

Zusätzlich betrifft die Erfindung ein Verfahren zur Abtastung wenigstens eines Wertes einer an einer elektronischen Komponente auftretenden Signalflanke, wobei
a) zu einem ersten Schaltzeitpunkt an die elektronische Komponente eine Spannung angelegt und/oder der elektronischen Komponente ein Strom zugeführt wird,
b) ein kapazitiver Speicher zu der elektronischen Komponente parallel geschaltet wird,
c) zu einem Messzeitpunkt der kapazitive Speicher von der elektronischen Komponente getrennt wird, wobei der Messzeitpunkt um eine Zeitdifferenz zeitlich hinter dem ersten Schaltzeitpunkt liegt,
d) die zum Messzeitpunkt an dem kapazitiven Speicher anliegende Spannung erfasst und digitalisiert wird.

Dabei wird der Verfahrensschritt b) insbesondere zum ersten Schaltzeitpunkt durchgeführt. Ferner werden die Verfahrensschritte a) bis d) bevorzugt bei einer unterschiedlichen Zeitdifferenz wenigstens einmal wiederholt. Auch kann die elektronische Komponente wenigstens einmal durch eine andere elektronische Komponente ausgetauscht werden, wonach oder wobei nach jedem Austausch die Verfahrensschritte a) bis d) wiederholt werden.

Zum Durchführen des Verfahrens wird insbesondere die erfindungsgemäße Anordnung verwendet, so dass die für das Verfahren verwendeten elektronischen Bauelemente den elektronischen Bauelementen der Anordnung entsprechen können und wie beschrieben weitergebildet sein können. Insbesondere kann ein periodisches Taktsignal erzeugt werden, wobei der Unterschied zwischen dem ersten Schaltzeitpunkt und dem Messzeitpunkt bevorzugt einem oder einem ganzzahligen Vielfachen des Taktzyklus des Taktsignals entspricht.

Ziel der Erfindung ist insbesondere die Abtastung schneller elektrischer Signalflanken und die Bewertung des Verlaufs, z.B. zur Messung von Induktivitäten oder Kapazitäten. Vorteilhaft ist hier der geringe technische und kostenmäßige Aufwand, um eine hohe Anzahl an Messkanälen zu erfassen, an denen jeweils nur kleine Kapazitäten oder Induktivitäten, von z.B. 1 µH, vorhanden sind.

Bei der Ansteuerung einer kapazitiv oder induktiv wirkenden elektronischen Komponente kommt es nach Anlegen eines Rechtecksignals zu einem zeitlichen verzögerten Spannungsverlauf, der von der Induktivität und/oder Kapazität und/oder vom ohmschen Widerstand der elektronischen Komponente abhängig ist. Diese zeitlichen Abläufe sind bei einer geringen Induktivität oder bei einer geringen Kapazität so schnell, dass eine Abtastung des Signalverlaufs mit einfachen, kostengünstigen Analog-Digital-Wandlern nicht möglich ist, da keine ausreichende Abtastrate erreicht wird.

Der erfindungsgemäßen Lösung liegt bevorzugt zugrunde, dass ein Mikroprozessor mit einer Pulsweitenmodulator-Einheit selbst ein Rechtecksignal zum Messobjekt (elektronische Komponente) schickt. Synchron dazu wird eine zweite Pulsweitenmodulator-Einheit gestartet. Der Rechteckimpuls der ersten Pulsweitenmodulator-Einheit erregt das Messobjekt oder mehrere Messobjekte. Die zweite Pulsweitenmodulator-Einheit unterbricht das zurückgeführte Signal vom Messobjekt zum Analog-Digital-Wandler des Mikrokontrollers mit einem Versatz von 1 bis n Prozessorzyklen (n steht für ein natürliche Zahl) und speichert dadurch den analogen Spannungswert in einem Kondensator (Abtast-Halte-Prinzip oder Sample and Hold Prinzip). Der Prozessorzyklus bestimmt dabei die Auflösung der Pulsweitenmodulator-Einheit. Ein langsamer Analog-Digital-Wandler (extern oder im Mikroprozessor integriert) kann damit das gespeicherte Signal abtasten. Durch das repetierende Signal der ersten Pulsweitenmodulator-Einheit und dem Jitter (Schwanken) von 1 bis n Prozessorzyklen der Impulsdauer des zweiten Pulsweitenmodulator-Signals relativ zu der Impulsdauer des ersten Pulsweitenmodulator-Signals kann in mehreren Zyklen die schnelle Impulsantwort des Messobjekts mit 1 bis n Abtastungen zeitlich diskretisiert und ausgewertet werden.

Die zweite Pulsweitenmodulator-Einheit schaltet dabei bevorzugt direkt das Freigabesignal eines Signalmultiplexers. Der Multiplexer dient damit zur Messkanalumschaltung, wie auch zur Steuerung der Abtast-HalteFunktion.

Ein bevorzugtes Merkmal der Erfindung ist das Zeitverhalten, d.h. dass Schaltsignale in einem Zeitfenster mit 1 bis n Taktzyklen zyklusgenau gesteuert werden können, wobei ein Zyklus insbesondere der schnellsten Befehlsausführungszeit oder der Taktgeschwindigkeit der Steuereinrichtung entspricht. Bevorzugt synchronisiert die Steuereinrichtung das gesamte Zeitverhalten auf die Wandlerzeiten des Analog-Digital-Wandlers. Somit ist es möglich, einen im Mikrocontroller integrierten oder einen externen Analog-Digital-Wandler zu verwenden, der im Vergleich zu den interessierenden zeitlichen Abläufen relativ langsam arbeitet.

Die Erfindung bietet insbesondere folgende Vorteile:
- Hohe Abtastraten sind mit einem Mikroprozessor möglich. Insbesondere ist eine bis zu hundertfach höhere analoge Abtastrate möglich als dies für einen typischen Mikroprozessor mit Analog-Digital-Wandler spezifiziert ist.
- Es ist eine einfache Signalkonditionierung für eine hohe Anzahl von Sensorkanälen möglich.
- Es ist keine analoge Aufbereitung erforderlich; es ist ein rein digitales System bis zum Analog-Digital-Wandler möglich; es sind einfache Multiplexer verwendbar.
- Es ist eine Reduzierung der Bauteilanzahl möglich.
- Es wird lediglich ein geringer Bauraum benötigt.
- Es ist eine Kostenreduzierung möglich.
- Die Anordnung und/oder das Verfahren sind weitgehend temperaturstabil, unter anderem durch eine geringe Anzahl von Halbleitern und geringe analoge Schaltungsanteile.

Die Erfindung wird nachfolgend anhand einer bevorzugten Ausführungsform unter Bezugnahme auf die Zeichnung beschrieben. In der Zeichnung zeigen:
- Fig. 1: ein schematisches Blockschaltbild einer Anordnung gemäß einer Ausführungsform der Erfindung,
- Fig. 2: ein teilweises Blockschaltbilds der Anordnung mit mehreren Messobjekten und
- Fig. 3: eine schematische Darstellung von Signalverläufen gemäß der Ausführungsform.

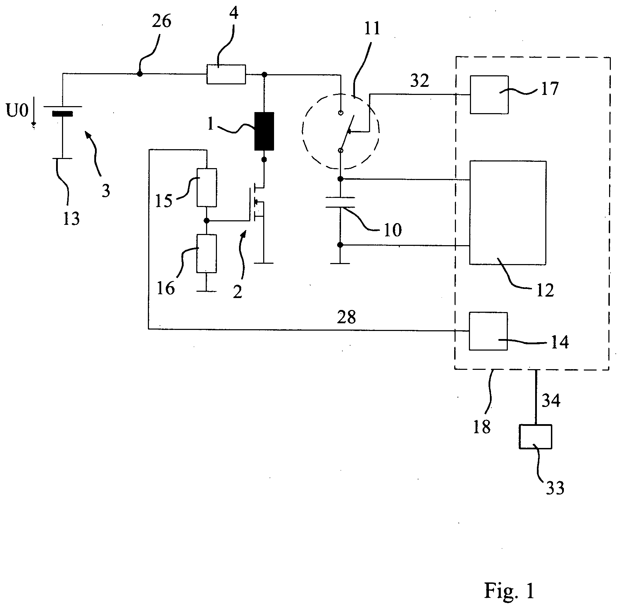

Aus Fig. 1 ist ein schematisches Blockschaltbild einer Anordnung gemäß einer Ausführungsform der Erfindung ersichtlich, wobei eine als Induktivität ausgebildete elektronische Komponente (Messobjekt) 1 mit einem durch einen Feldeffekttransistor gebildeten ersten Schalter 2 in Reihe geschaltet ist und dadurch eine erste Reihenschaltung bildet. An das Messobjekt 1 ist unter Zwischenschaltung eines ohmschen Widerstands 4 eine Spannungsquelle 3 angeschlossen, mittels welcher eine elektrische Spannung an die erste Reihenschaltung angelegt wird. Die Spannungsquelle ist mit ihrem einen Anschluss mit dem Widerstand 4 und mit ihrem anderen Anschluss mit Masse 13 verbunden. Ferner ist der Source-Anschluss des Feldeffekttransistors 2 mit Masse 13 verbunden. Zu der ersten Reihenschaltung ist eine zweite Reihenschaltung parallel geschaltet, die einen als Kondensator ausgebildeten kapazitiven Speicher 10 und einen dazu in Reihe geschalteten zweiten Schalter 11 aufweist. Dabei ist der nicht an dem Schalter 11 angeschlossene Anschluss des kapazitiven Speichers 10 mit Masse 13 verbunden. Ferner ist zu dem kapazitiven Speicher 10 ein Analog-Digital-Wandler 12 parallel geschaltet.

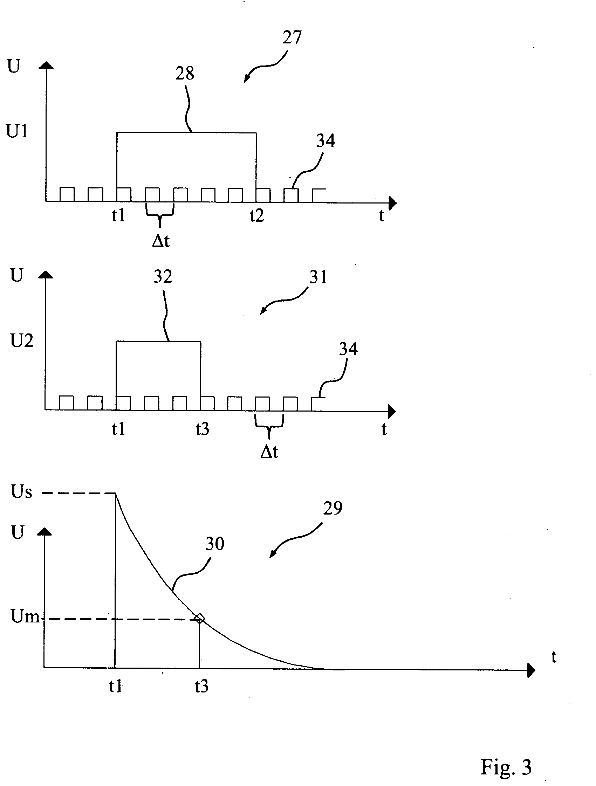

Eine erste Pulsweitenmodulator-Einheit 14 ist über einen aus zwei Widerständen 15 und 16 gebildeten Spannungsteiler mit dem Gate-Anschluss des Feldeffekttransistors 2 verbunden, welcher somit als Schalter dient, der mittels eines von der Pulsweitenmodulator-Einheit 14 abgegebenen Schaltsignals 28 (siehe Fig. 3) geöffnet und/oder geschlossen wird oder werden kann. Abhängig von dem ersten Schaltsignal 28 kann somit die elektronische Komponente 1 gegen Masse 13 geschaltet oder davon getrennt werden. Zwar ist der Schalter 2 hier durch einen Feldeffekttransistor gebildet, der Schalter 2 kann aber auch durch ein anderes geeignetes Bauelement gebildet sein, mit dem ein elektrischer Schalter realisierbar ist. Ferner kann der Schalter 11 mittels eines von einer Pulsweitenmodulator-Einheit 17 abgegebenen zweiten Schaltsignals 32 (siehe Fig. 3) geschlossen und/oder geöffnet werden. Die beiden Pulsweitenmodulator-Einheiten 14 und 17 sowie der Digital-Analog-Wandler 12 sind dabei in einen Mikroprozessor oder Mikrocontroller 18 integriert. Mittels eines Taktgebers 33 wird ein Taktsignal 34 erzeugt, welches dem Mikroprozessor oder Mikrocontroller 18 zugeführt wird. Der Mikroprozessor oder Mikrocontroller bildet eine Steuereinrichtung, die alternativ auch von einem FPGA oder ASIC gebildet sein kann.

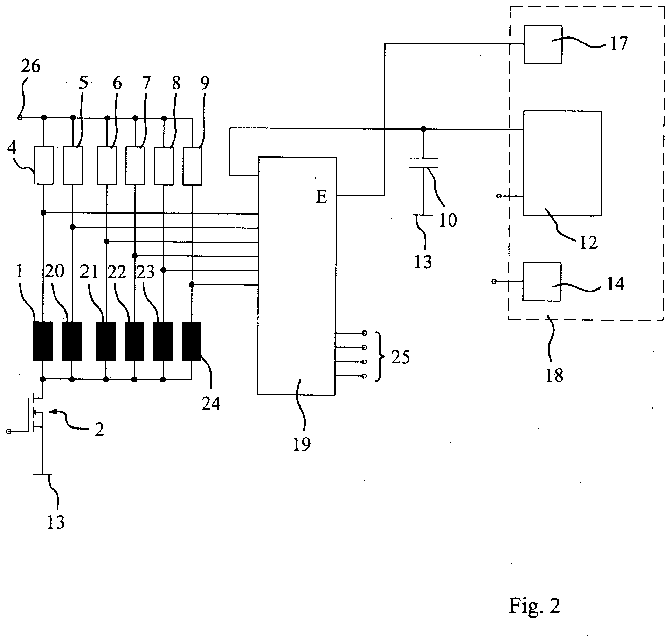

Der Schalter 11 ist mittels eines Multiplexers 19 gebildet, was aus Fig. 2 ersichtlich ist. Dabei ist die Pulsweitenmodulator-Einheit 17 mit dem Freigabeeingang E des Multiplexers 19 verbunden, sodass der Kondensator 10 durch Aktivieren des Freigabeeingangs E (dies entspricht einem Betätigen des Schalters 11) zu der elektronische Komponente 1 parallel geschaltet wird oder werden kann. Durch Deaktivieren des Freigabeeingangs E mittels der Pulsweitenmodulator-Einheit 17 bzw. mittels des von dieser abgegebenen zweiten Schaltsignals 32 wird der Kondensator 10 von der elektronischen Komponente 1 getrennt.

Aus Fig. 2 ist ersichtlich, dass fünf zusätzliche elektronische Komponenten (Messobjekte) 20 bis 24, die jeweils als Induktivitäten ausgebildet sind, einenends mit dem Multiplexer 19 und anderenends mit dem an den Feldeffekttransistor 2 angeschlossenen Ausgang der elektronischen Komponente 1 verbunden sind. Da die elektronischen Komponenten 1 und 20 bis 24 mit unterschiedlichen Anschlüssen des Multiplexers 19 verbunden sind, kann der Kondensator 10 mittels des Multiplexer 19 mit jeder dieser elektronischen Komponenten verbunden werden. Dabei ist der Kondensator 10 mittels des Multiplexer 19 zu einem Zeitpunkt aber immer nur mit einer oder mit keiner der elektronische Komponenten verbunden. Um auswählen zu können, welche der elektronischen Komponenten mittels des Multiplexers 19 mit dem Kondensator 10 verbunden ist, weist der Multiplexer 19 mehrere Eingänge 25 auf, an die zum Auswählen der jeweiligen Verbindung geeignete Signale angelegt werden oder werden können. Somit ist es möglich, nacheinander die Spannungen an den unterschiedlichen elektronischen Komponenten 1 und 20 bis 24 zu messen.

Wie die elektronische Komponente 1, die über den Widerstand 4 mit dem aus Fig. 1 ersichtlichen Knoten 26 verbunden ist, sind auch die anderen elektronischen Komponenten 20 bis 24 mit ihren dem Schalter 2 abgewandten Anschlüssen jeweils über einen ohmschen Widerstand 5 bis 9 mit dem Knoten 26 elektrisch verbunden.

Aus Fig. 3 sind mehrere Signalverläufe ersichtlich, anhand derer die Funktionsweise der Messanordnung erläutert wird. In der Darstellung 27 ist das von der Pulsweitenmodulator-Einheit 14 abgegebene erste Schaltsignal 28 ersichtlich, welches zu einem ersten Schaltzeitpunkt t1 sprunghaft auf eine Spannung U1 ansteigt. Hierdurch wird der Feldeffekttransistor 2 leitend geschaltet bzw. der durch den Transistor 2 gebildete Schalter geschlossen, sodass eine Spannung an die Induktivität 1 angelegt wird. Zu einem späteren zweiten Schaltzeitpunkt t2 wird das erste Schaltsignal 28 abgeschaltet, was eine Sperrung des Feldeffekttransistors 2 zufolge hat. Da der Strom durch ein Spule stetig ist, wird zum Zeitpunkt t1 in der Induktivität 1 eine aus der Darstellung 29 ersichtliche Spannung 30 induziert, die ausgehend von einer Spitzenspannung Us mit fortschreitender Zeit t abklingt. Aus der Darstellung 31 ist der zeitliche Verlauf des von der Pulsweitenmodulator-Einheit 17 abgegebenen zweiten Schaltsignals 32 ersichtlich, welches ebenfalls zum ersten Schaltzeitpunkt t1 sprunghaft auf einen Spannungswert U2 ansteigt. Hierdurch wird der Schalter 11 geschlossen, sodass die an der Induktivität 1 anliegende Spannung auch an dem Kondensator 10 anliegt. Zu einem späteren Messzeitpunkt t3 wird das zweite Schaltsignal 32 abgeschaltet und dadurch der Schalter 11 geöffnet, sodass der Kondensator 10 von der Induktivität 1 getrennt wird. Die zum Messzeitpunkt t3 an der Induktivität 1 anliegende Spannung Um wird von dem Kondensator 10 solange gehalten, dass der Analog-Digital-Wandler 12 die Spannung Um erfassen und digitalisieren kann. Die digitalisierte Spannung Um steht dann dem Mikroprozessor 18 zur weiteren Verarbeitung zur Verfügung. Gemäß der dargestellten Ausführungsform gilt: t1 < t3 < t2. Dabei entspricht der zeitliche Unterschied zwischen dem Messzeitpunkt t3 und dem ersten Schaltzeitpunkt t1 einem ganzzahligen Vielfachen des Taktzyklus Δt des Taktsignals 34: t3 - t1 = n ^{∗} Δt, n ist eine natürliche Zahl.

Bei einer beispielhaften Ausgestaltung liegt die zeitliche Differenz zwischen t2 und t1 bei ca. 2 bis 3 ps. Die Induktivität liegt bei ca. 10 µH. Ferner hat der Prozessorzyklus Δt eine Dauer von etwa 50 ns, sodass der zeitliche Unterschied zwischen dem ersten Schaltzeitpunkt t1 und dem Messzeitpunkt t3 auf ganzzahlige Vielfache von 50 ns eingestellt ist oder werden kann. Durch Wiederholen der Messung bei unterschiedlichen zeitlichen Differenzen zwischen dem Messzeitpunkt t3 und dem ersten Schaltzeitpunkt t1 kann die wiederkehrende Spannung 30 in zeitlichen Schritten abgetastet werden, die dem Prozessorzyklus Δt oder einem ganzzahligen Vielfachen davon entsprechen. Wie aus Fig. 3 ersichtlich, weisen die Verläufe der beiden Schaltsignale 28 und 32 jeweils ein Rechtecksignal auf.

### Bezugszeichenliste

- 1: Induktivität
- 2: Schalter / Feldeffekttransistor
- 3: Spannungsquelle
- 4: Widerstand
- 5: Widerstand
- 6: Widerstand
- 7: Widerstand
- 8: Widerstand
- 9: Widerstand
- 10: Kondensator
- 11: Schalter
- 12: Analog-Digital-Wandler
- 13: Masse
- 14: Pulsweitenmodulator-Einheit
- 15: Widerstand
- 16: Widerstand
- 17: Pulsweitenmodulator-Einheit
- 18: Mikroprozessor
- 19: Multiplexer
- 20: Induktivität
- 21: Induktivität
- 22: Induktivität
- 23: Induktivität
- 24: Induktivität
- 25: Eingänge
- 26: Knoten
- 27: Darstellung
- 28: erstes Schaltsignal
- 29: Darstellung
- 30: Spannung an Induktivität
- 31: Darstellung
- 32: zweites Schaltsignal
- 33: Taktgeber
- 34: Taktsignal
- U: Spannung
- U0: Spannung der Spannungsquelle
- U1: Schaltspannung des ersten Schaltsignals
- U2: Schaltspannung des zweiten Schaltsignals
- Us: Spitzenspannung an Induktivität
- Um: Messspannung
- E: Freigabeeingang des Multiplexers
- t: Zeit
- t1: erster Schaltzeitpunkt
- t2: zweiter Schaltzeitpunkt
- t3: Messzeitpunkt
- Δt: Taktzyklus des Taktsignals

## Patentansprüche

1. Anordnung zur Messung wenigstens eines Wertes einer an einer elektronischen Komponente (1) anliegenden Spannung, mit
der elektronischen Komponente (1),
einem ersten Signalgeber (14), von dem ein erstes Schaltsignal (28) abgebbar ist, einem mit dem ersten Signalgeber (14) gekoppelten ersten Schalter (2), der mittels des ersten Schaltsignals (28) schaltbar ist, wobei die elektronische Komponente (1) mit dem ersten Schalter (2) in Reihe geschaltet und mittels diesem zu einem ersten Schaltzeitpunkt (t1) mit einer elektrischen Energiequelle (3) koppelbar ist,
einem zweiten Signalgeber (17), von dem ein zweites Schaltsignal (32) abgebbar ist, und
einem Analog-Digital-Wandler (12),
**gekennzeichnet durch**
einen mit dem zweiten Signalgeber (17) gekoppelten aus einem Transistor gebildeten zweiten Schalter (11), der mittels des zweiten Schaltsignals (32) schaltbar ist, und
einen kapazitiven Speicher (10), der mit dem zweiten Schalter (11) in Reihe geschaltet und mittels diesem zu der von der elektronischen Komponente (1) und dem ersten Schalter (2) gebildeten Reihenschaltung direkt parallel geschaltet und zu einem Messzeitpunkt (t3) getrennt ist, der um eine Zeitdifferenz zeitlich hinter dem ersten Schaltzeitpunkt (t1) liegt,
wobei der Analog-Digital-Wandler (12) zu dem kapazitiven Speicher (10) parallel geschaltet ist.

2. Anordnung nach Anspruch 1,
**dadurch gekennzeichnet, dass**
die elektronische Komponente (1) mit der elektrischen Energiequelle (3) unter Zwischenschaltung wenigstens eines ohmschen Widerstands (4) gekoppelt oder koppelbar ist.

3. Anordnung nach Anspruch 1 oder 2,
**dadurch gekennzeichnet, dass**
der kapazitive Speicher einen Kondensator (10) aufweist oder von diesem gebildet ist.

4. Anordnung nach einem der vorangehenden Ansprüche,
**dadurch gekennzeichnet, dass**
der erste Schalter einen Transistor (2) aufweist oder von diesem gebildet ist.

5. Anordnung nach einem der vorangehenden Ansprüche,
**dadurch gekennzeichnet, dass**
der erste Signalgeber eine Pulsweitenmodulator-Einheit (14) aufweist oder von dieser gebildet ist, wobei das erste Schaltsignal (28) ein Rechtecksignal ist oder aufweist.

6. Anordnung nach Anspruch 5,
**dadurch gekennzeichnet, dass**
der zweite Signalgeber eine Pulsweitenmodulator-Einheit (17) aufweist oder von dieser gebildet ist, wobei das zweite Schaltsignal (32) ein Rechtecksignal ist oder aufweist, dessen Impulsdauer kürzer als die Impulsdauer des Rechtecksignals des ersten Schaltsignals (28) ist.

7. Anordnung nach einem der vorangehenden Ansprüche,
**dadurch gekennzeichnet, dass**
der zweite Schalter von einem Multiplexer (19) gebildet ist oder mit einem Multiplexer gekoppelt ist, wobei der kapazitive Speicher (10) mittels des Multiplexers (19) zu wenigstens einer mit dem ersten Schalter (2) in Reihe geschalteten anderen elektronischen Komponente (20) oder zu einer aus der anderen elektronischen Komponente (20) und dem ersten Schalter (2) gebildeten Reihenschaltung parallel schaltbar ist.

8. Anordnung nach einem der vorangehenden Ansprüche,
**dadurch gekennzeichnet, dass**
die beiden Signalgeber (14, 17) und der Analog-Digital-Wandler (12) in einem Mikroprozessor oder Mikrokontroller (18) integriert sind.

9. Anordnung nach einem der vorangehenden Ansprüche,
**dadurch gekennzeichnet, dass**
die beiden Signalgeber (14, 17) und der Analog-Digital-Wandler (12) in einer getakteten Steuereinrichtung (18) integriert sind, wobei sich die Impulsenden der beiden Schaltsignale (28, 32) um einen oder ein ganzzahliges Vielfaches des Taktzyklus der Steuereinrichtung (18) unterscheiden.

10. Verwendung der Anordnung nach einem der vorangehenden Ansprüche zur Bestimmung der Induktivität oder der Kapazität der elektronischen Komponente (1).

11. Verfahren zur Abtastung wenigstens eines Wertes einer an einer elektronischen Komponente (1) auftretenden Signalflanke mittels einer Anordnung nach einem der vorhergehenden Ansprüche, wobei
a) zu einem ersten Schaltzeitpunkt (t1) an die elektronische Komponente (1) eine Spannung angelegt und/oder der elektronischen Komponente (1) ein Strom zugeführt wird,
b) die aus dem kapazitiven Speicher (10) und dem zweiten Schalter (11) gebildete Reihenschaltung zu der aus der elektronischen Komponente (1) und dem ersten Schalter (2) gebildeten Reihenschaltung direkt parallel geschaltet wird,
c) zu einem Messzeitpunkt (t3) der kapazitive Speicher (10) von der elektronischen Komponente (1) getrennt wird, wobei der Messzeitpunkt (t3) um eine Zeitdifferenz zeitlich hinter dem ersten Schaltzeitpunkt (t1) liegt,
d) die zum Messzeitpunkt (t3) an dem kapazitiven Speicher (10) anliegende Spannung erfasst und digitalisiert wird.

12. Verfahren nach Anspruch 11,
**dadurch gekennzeichnet, dass**
der Verfahrensschritt b) zum ersten Schaltzeitpunkt (t1) durchgeführt wird.

13. Verfahren nach Anspruch 11 oder 12,
**dadurch gekennzeichnet, dass**
die Verfahrensschritte a) bis d) bei einer unterschiedlichen Zeitdifferenz wiederholt werden.

14. Verfahren nach einem der Ansprüche 11 bis 13,
**dadurch gekennzeichnet, dass**
ein periodisches Taktsignal (34) erzeugt wird, wobei die Zeitdifferenz einem oder einem ganzzahligen Vielfachen des Taktzyklus (Δt) des Taktsignals (34) entspricht.

## Claims

1. Arrangement for measuring at least one value of a voltage applied to an electronic component (1), having the electronic component (1),
a first signal transmitter (14), from which a first switching signal (28) is able to be output,
a first switch (2), which is coupled to the first signal transmitter (14) and which is able to be switched by means of the first switching signal (28), wherein the electronic component (1) is connected in series with the first switch (2) and is able to be coupled by means of said first switch to an electrical energy source (3) at a first switching time (t1),
a second signal transmitter (17), from which a second switching signal (32) is able to be output,
and
an analogue-to-digital converter (12),
**characterized by**
a second switch (11), which is coupled to the second signal transmitter (17), is formed from a transistor and is able to be switched by means of the second switching signal (32),
and
a capacitive store (10), which is connected in series with the second switch (11) and by means of said second switch is connected directly in parallel with the series circuit formed by the electronic component (1) and the first switch (2) and is disconnected at a measurement time (t3) that lies in terms of time behind the first switching time (t1) by a time difference,
wherein the analogue-to-digital converter (12) is connected in parallel with the capacitive store (10).

2. Arrangement according to Claim 1,
**characterized in that**
the electronic component (1) is coupled or is able to be coupled to the electrical energy source (3) with the interconnection of at least one ohmic resistor (4).

3. Arrangement according to Claim 1 or 2,
**characterized in that**
the capacitive store has a capacitor (10) or is formed thereby.

4. Arrangement according to one of the preceding claims,
**characterized in that**
the first switch has a transistor (2) or is formed thereby.

5. Arrangement according to one of the preceding claims,
**characterized in that**
the first signal transmitter has a pulse-width-modulator unit (14) or is formed thereby, wherein the first switching signal (28) is or has a square-wave signal.

6. Arrangement according to Claim 5,
**characterized in that**
the second signal transmitter has a pulse-width-modulator unit (17) or is formed thereby, wherein the second switching signal (32) is or has a square-wave signal, the pulse duration of which is shorter than the pulse duration of the square-wave signal of the first switching signal (28).

7. Arrangement according to one of the preceding claims,
**characterized in that**
the second switch is formed by a multiplexer (19) or is coupled to a multiplexer, wherein the capacitive store (10) is able to be connected in parallel by means of the multiplexer (19) with at least one other electronic component (20) connected in series with the first switch (2) or with a series circuit formed from the other electronic component (20) and the first switch (2).

8. Arrangement according to one of the preceding claims,
**characterized in that**
the two signal transmitters (14, 17) and the analogue-to-digital converter (12) are integrated in a microprocessor or microcontroller (18).

9. Arrangement according to one of the preceding claims,
**characterized in that**
the two signal transmitters (14, 17) and the analogue-to-digital converter (12) are integrated in a clocked control device (18), wherein the pulse ends of the two switching signals (28, 32) differ by one clock cycle or an integer multiple of the clock cycle of the control device (18).

10. Use of the arrangement according to one of the preceding claims to determine the inductance or the capacitance of the electronic component (1).

11. Method for sampling at least one value of a signal edge arising at an electronic component (1) by means of an arrangement according to one of the preceding claims, wherein
a) a voltage is applied to the electronic component (1) and/or a current is supplied to the electronic component (1) at a first switching time (t1),
b) the series circuit formed from the capacitive store (10) and the second switch (11) is connected directly in parallel with the series circuit formed from the electronic component (1) and the first switch (2),
c) the capacitive store (10) is disconnected from the electronic component (1) at a measurement time (t3), wherein the measurement time (t3) lies in terms of time behind the first switching time (t1) by a time difference,
d) the voltage applied to the capacitive store (10) at the measurement time (t3) is detected and digitized.

12. Method according to Claim 11,
**characterized in that**
method step b) is carried out at the first switching time (t1) .

13. Method according to Claim 11 or 12,
**characterized in that**
method steps a) to d) are repeated in the case of a different time difference.

14. Method according to one of Claims 11 to 13,
**characterized in that**
a periodic clock signal (34) is generated, wherein the time difference corresponds to one clock cycle or an integer multiple of the clock cycle (Δt) of the clock signal (34).

## Revendications

1. Dispositif servant à mesurer au moins une valeur d'une tension associée à un composant électronique (1), avec :
le composant électronique (1) ;
un premier transmetteur de signaux (14) à partir duquel un premier signal de connexion (28) peut être transmis ;
un premier contacteur (2) couplé au premier transmetteur de signaux (14) et pouvant être connecté à l'aide du premier signal de connexion (28), le composant électronique (1) étant connecté en série au premier contacteur (2) et pouvant être couplé à une source d'énergie électrique (3) à l'aide de celui-ci à un premier instant de connexion (t1) ;
un deuxième transmetteur de signaux (17) à partir duquel un deuxième signal de connexion (32) peut être transmis ; et
un convertisseur analogique-numérique (12) ;
**caractérisé par** :
un deuxième contacteur (11) couplé au deuxième transmetteur de signaux (17), constitué d'un transistor et pouvant être connecté à l'aide du deuxième signal de connexion (32) ; et
une mémoire capacitive (10) connectée en série au deuxième contacteur (11) et directement connectée en parallèle à l'aide de celui-ci au circuit en série composé du composant électronique (1) et du premier contacteur (2) et en étant séparé à un instant de mesure (t3) correspondant dans le temps à une différence de temps suivant le premier instant de connexion (t1) ;
le convertisseur analogique-numérique (12) étant connecté parallèlement à la mémoire capacitive (10).

2. Dispositif selon la revendication 1, **caractérisé en ce que** le composant électronique (1) est couplé ou peut être couplé à la source d'énergie électrique (3) en interconnectant au moins une résistance (4) ohmique.

3. Dispositif selon la revendication 1 ou 2, **caractérisé en ce que** la mémoire capacitive comporte un condensateur (10) ou est composée de celui-ci.

4. Dispositif selon l'une quelconque des revendications précédentes, **caractérisé en ce que** le premier contacteur comporte un transistor (2) ou est composé de celui-ci.

5. Dispositif selon l'une quelconque des revendications précédentes, **caractérisé en ce que** le premier transmetteur de signaux comporte une unité de modulation de largeur (14) ou est composé de celle-ci, le premier signal de connexion (28) étant ou comportant un signal rectangulaire.

6. Dispositif selon la revendication 5, **caractérisé en ce que** le deuxième transmetteur de signaux comporte une unité de modulation de largeur (17) ou est composé de celle-ci, le deuxième signal de connexion (32) étant ou comportant un signal rectangulaire dont la durée d'impulsion est plus courte que la durée d'impulsion du signal rectangulaire du premier signal de connexion (28) .

7. Dispositif selon l'une quelconque des revendications précédentes, **caractérisé en ce que** le deuxième contacteur est composé d'un multiplexeur (19) ou est couplé à un multiplexeur, la mémoire capacitive (10) pouvant être connectée, à l'aide du multiplexeur (19), à au moins un autre composant électronique (20) connecté en série au premier contacteur (2) ou en parallèle à un circuit en série composé de l'autre composant électronique (20) et du premier contacteur (2) .

8. Dispositif selon l'une quelconque des revendications précédentes, **caractérisé en ce que** les deux transmetteurs de signaux (14, 17) et le convertisseur analogique-numérique (12) sont intégrés dans un microprocesseur ou microcontrôleur (18).

9. Dispositif selon l'une quelconque des revendications précédentes, **caractérisé en ce que** les deux transmetteurs de signaux (14, 17) et le convertisseur analogique-numérique (12) sont intégrés dans un dispositif de commande (18) cadencé, les extrémités d'impulsion des deux signaux de connexion (28, 32) se distinguant d'un cycle d'horloge du dispositif de commande (18) ou d'un multiple entier dudit cycle.

10. Utilisation du dispositif selon l'une quelconque des revendications précédentes pour déterminer l'inductivité ou la capacité du composant électronique (1) .

11. Procédé de balayage d'au moins une valeur d'un flanc de signal se produisant au niveau d'un composant électronique (1) au moyen d'un dispositif selon l'une quelconque des revendications précédentes :
a) à un premier instant de connexion (t1), une tension étant appliquée à un composant électronique (1) et/ou un courant étant amené au composant électronique (1) ;
b) le circuit en série composé de la mémoire capacitive (10) et du deuxième contacteur (11) étant connecté directement en parallèle au circuit en série composé du composant électronique (1) et du premier contacteur (2) ;
c) à un instant de mesure (t3), la mémoire capacitive (10) étant séparée du composant électronique (1), l'instant de mesure (t3) correspondant dans le temps à une différence de temps suivant le premier instant de connexion (t1) ;
d) la tension appliquée à la mémoire capacitive (10) à l'instant de mesure (t3) étant détectée et numérisée.

12. Procédé selon la revendication 11, **caractérisé en ce que** l'étape de procédé b) est mise en œuvre au premier instant de connexion (t1).

13. Procédé selon la revendication 11 ou 12, **caractérisé en ce que** les étapes de procédé a) à d) sont répétées pour un écart de temps différent.

14. Procédé selon l'une quelconque des revendications 11 à 13, **caractérisé en ce qu'**un signal d'horloge (34) périodique est produit, la différence de temps correspondant à un cycle d'horloge (Δt) du signal d'horloge (34) ou à un multiple entier de celui-ci.
